# EUROPÄISCHE PATENTSCHRIFT

(11) **EP 1 917 712 B1**
(45) Veröffentlichungstag und Bekanntmachung des Hinweises auf die Patenterteilung: **24.10.2018**
(21) Anmeldenummer: 06778052.8
(22) Anmeldetag: 28.07.2006
(51) Int. Cl.: H02M 7/483, H02P 3/22, H03K 17/10, H02M 1/32

(54) **PULSWIDERSTAND (BREMSWIDERSTAND) FÜR EINEN UMRICHTER IM HÖHEREN SPANNUNGS- UND LEISTUNGSBEREICH**
PULSE RESISTOR (BRAKING RESISTOR) FOR A CONVERTER AT ELEVATED VOLTAGE AND POWER LEVEL
RÉSISTANCE À IMPULSIONS (RÉSISTANCE DE FREINAGE) POUR UN CONVERTISSEUR DANS LA PLAGE DE TENSION ET DE PUISSANCE SUPÉRIEURE

(30) Priorität: 26.08.2005 DE 102005040549
(43) Veröffentlichungstag der Anmeldung: 07.05.2008
(73) Patentinhaber: Siemens Aktiengesellschaft, 80333 München (DE)
(72) Erfinder: SOMMER, Rainer, 91336 Heroldsbach (DE)
(86) Internationale Anmeldenummer: PCT/EP2006/064786
(87) Internationale Veröffentlichungsnummer: WO 2007/023061

(56) Entgegenhaltungen:
- DE-A1- 10 103 031
- JP-A- 62 277 081

## Beschreibung

Die Erfindung bezieht sich auf einen Pulswiderstand für einen Umrichter im höheren Spannungs- und Leistungsbereich.

Für geregelte elektrische Antriebe und Energieversorgungsanlagen werden in höheren Spannungsbereichen zunehmend Umrichter mit eingeprägter Gleichspannung verwendet. Ein solcher Umrichtertyp wird auch als U-Umrichter bezeichnet. Zu den höheren Spannungsbereichen sind die genormten Mittelspannungen 2,3kV, 3,3kV, 4,16kV und 6,9kV zu zählen.

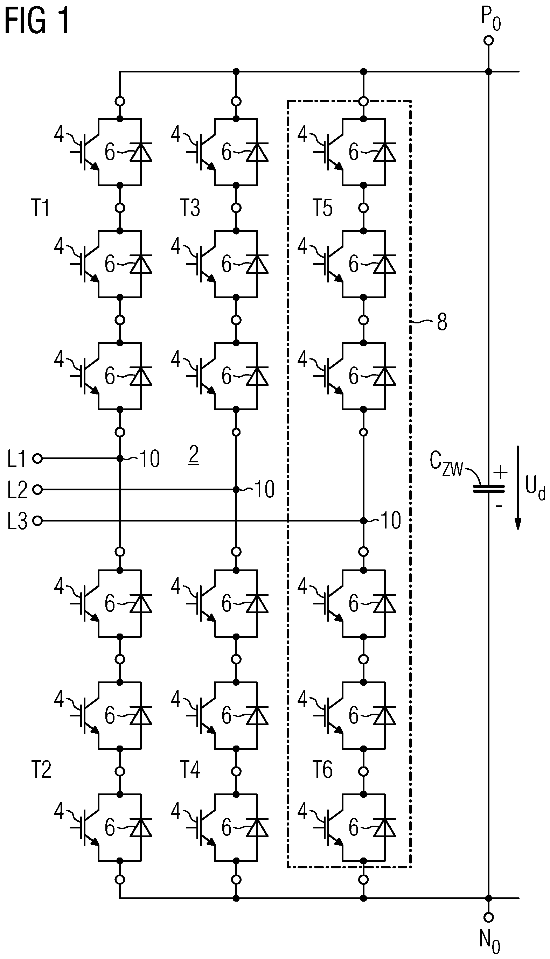

In der FIG 1 ist ein Ersatzschaltbild eines aus dem Stand der Technik bekannten U-Umrichters dargestellt, von dem wegen der Übersichtlichkeit nur ein lastseitiger dreiphasiger Stromrichter 2 veranschaulicht ist. Wegen des hohen Spannungsbereiches weisen die Stromrichterventile T1-T6 dieses lastseitigen dreiphasigen Stromrichters 2 jeweils mehrere elektrisch in Reihe geschaltete abschaltbare Halbleiterschalter 4 auf, denen jeweils eine Diode 6 antiparallel geschaltet sind. Da jedes Stromrichterventil T1-T6 drei abschaltbare Halbleiterschalter 4 aufweist, wird diese Stromrichtertopologie auch als Zweipunkt-Stromrichter mit der Reihenschaltzahl Drei bezeichnet. Jeweils zwei Stromrichterventile T1,T2 bzw. T3,T4 bzw. T5,T6 bilden einen Brückenzweig 8, der einen Phasenbaustein des Zweipunkt-Stromrichters 2 darstellt. Jeder Verbindungspunkt 10 zweier Stromrichterventile T1,T2 bzw. T3,T4 bzw. T5,T6 bildet einen Anschluss L1 bzw. L2 bzw. L3 für den Anschluss einer dreiphasigen Last, beispielsweise eines Drehstrommotors. Die drei Phasenbausteine 8 des dreiphasigen Stromrichters 2 sind mittels zweier Sammelschienen P₀ und N₀ elektrisch parallel geschaltet. Zwischen diesen beiden Sammelschienen P₀ und N₀ ist ein Gleichspannungs-Zwischenkreiskondensator C_{ZW} geschaltet, der beispielsweise aus einem oder einer Anzahl mehrerer elektrisch in Reihe und/oder parallel geschalteter Kondensatoren besteht. An diesem Gleichspannungs-Zwischenkreiskondensator C_{ZW} liegt eine Gleichspannung U_{d}. In diesem Ersatzschaltbild eines Zweipunkt-Stromrichters mit der Reihenschaltzahl Drei sind als abschaltbare Halbleiterschalter 4 **I**nsulated-**G**ate-**B**ipolar-**T**ransistoren (IGBT) vorgesehen. Die Reihenschaltzahl ist abhängig von der an Gleichspannungs-Zwischenkreiskondensator C_{ZW} anstehenden Gleichspannung U_{d} und der Sperrfähigkeit im Handel erhältlicher IGBT's.

Bei einer temporären Energierückspeisung in den Gleichspannungs-Zwischenkreiskondensator C_{ZW} kann die am Gleichspannungs-Zwischenkreiskondensator C_{ZW} anstehende Gleichspannung U_{d} derart ansteigen, dass ein zulässiger Maximalwert dieser Gleichspannung überschritten wird. Ein derartiger Fall tritt insbesondere beim Bremsbetrieb eines an den Anschlüssen L1,L2 und L3 angeschlossenen Drehstrommotors auf. Auch andere Ursachen, die im Allgemeinen von kurzer Dauer sind, beispielsweise schnelle Schwankungen der Netzspannung eines speisenden Netzes oder Lastschwankungen, können zu derartigen Überspannungen führen. Um diese Problematik zu beherrschen, sind folgende Maßnahmen bekannt:
- Anschluss eines rückspeisefähigen Stromrichters, der elektrisch parallel zum Gleichspannungs-Zwischenkreiskondensator C_{ZW} geschaltet wird. Dadurch kann die überschüssige Energie aus dem Gleichspannungs-Zwischenkreiskondensator C_{ZW} in ein aufnahmefähiges Netz zurückgeführt werden.
- Anschluss eines pulsgesteuerten Widerstandes an den Sammelschienen P₀,N₀ des Gleichspannungs-Zwischenkreises, womit die überschüssige Energie des Gleichspannungs-Zwischenkreiskondensators C_{ZW} in Wärme umgewandelt wird.

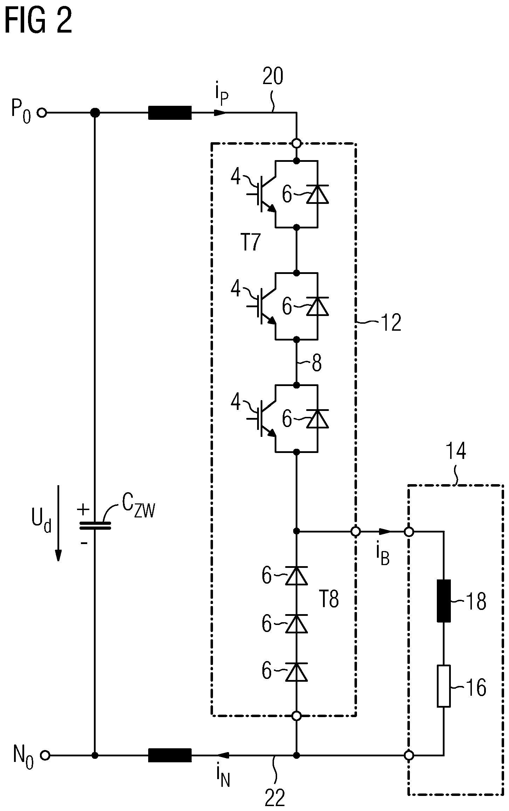

In der FIG 2 ist ein Ersatzschaltbild eines pulsgesteuerten Widerstandes, der auch als Pulswiderstand bezeichnet, dargestellt. Dieser bekannte Pulswiderstand besteht aus einem Stellglied 12 und einem Widerstandselement 14. Als Stellglied 12 wird ein Phasenbaustein 8 verwendet, bei dem die abschaltbaren Halbleiterschalter 4 des unteren Stromrichterventils T8 nicht benötigt werden. Die Realisierung des oberen Stromrichterventils T7 dieses Phasenbausteins 8 entspricht der Realisierung des Stromrichterventils T1 bzw. T3 bzw. T5 des lastseitigen dreiphasigen Stromrichters 2 nach FIG 1. Zum Verständnis sind im Ersatzschaltbild die abschaltbaren Halbleiterschalter 4 des unteren Stromrichterventils T8 des Stellgliedes 12 des Pulswiderstandes nicht explizit dargestellt. Diese können jedoch im Phasenbaustein 8 vorhanden sein, werden jedoch bei der Funktion "Bremsen" nicht angesteuert. Elektrisch parallel zum unteren Stromrichterventil T8 mit der Reihenschaltzahl Drei ist das Widerstandselement 14 geschaltet. Dieses Widerstandselement 14 weist einen ohmschen und einen induktiven Teil 16 und 18 auf. Der induktive Teil 18 veranschaulicht seine parasitäre Induktivität. Dieser Pulswiderstand weist für hohe Spannungen folgende Nachteile auf:
a) Die Ströme i_{P} und i_{N} in den Zuleitungen 20 und 22 des Pulswiderstandes weisen eine sehr hohe Stromsteilheit di/dt auf, die zur Abstrahlung elektromagnetischer Störungen führen.
b) Um auftretende Spannungen an den abschaltbaren Halbleiterschaltern 4 zu begrenzen, müssen die Zuleitungen 20 und 22 räumlich kurz und induktivitätsarm ausgeführt werden.
c) Dieser Pulswiderstand hat Zweipunktverhalten und erzeugt im periodischen Pulsbetrieb eine hohe Wechselstromkomponente des Stromes i_{P} und i_{N} in den Zuleitungen 20 und 22.
d) Dieser Pulswiderstand benötigt zu seiner Funktion einen Gleichspannungskondensator C_{ZW} in möglichst unmittelbarer, räumlicher Nähe. D.h., dass dieser Pulswiderstand unmittelbar räumlich in der Nähe des Gleichspannungs-Zwischenkreiskondensators C_{ZW} angeordnet sein muss.

Die Nachteile der Punkte a) und b) sind insbesondere störend, wenn der pulsgesteuerte Widerstand 14 als optionaler Zusatz zum Stromrichter 2 eingesetzt werden soll. Der Nachteil gemäß Punkt c) führt zu einer erhöhten Welligkeit der Gleichspannung U_{d} des Gleichspannnungs-Zwischenkreiskondensators C_{ZW} des Zweipunkt-Stromrichters 2 mit der Reihenschaltzahl Drei. Diese erhöhte Welligkeit verursacht unerwünschte Rückwirkungen auf die Funktion anderer an den Sammelschienen P₀,N₀ angeschlossener Stromrichter. Durch den Nachteil gemäß Punkt d) kann dieser Pulswiderstand nicht bei Stromrichtertopologien verwendet werden, die keinen Gleichspannungs-Zwischenkreiskondensator C_{ZW} aufweisen.

Aus der JP 62 277081 A ist ein Pulswiderstand für einen Umrichter mit einem Widerstandselement (Bremswiderstand) bekannt. Um den Bremswiderstand vor Überhitzung aufgrund des Defekts eines Bremstransistorelements zu verhindern, wird die Wärme erzeugenden Wirkung des Widerstands aufgrund rückgespeister Energie auf einen bestimmten Wert begrenzt. Wenn ein Motor normal arbeitet, ist ein Schaltelement geschlossen, um einen Bremswiderstand in Reihe mit einem Transistor zu verbinden. Der Transistor ist dann mittels Komparator ausgeschaltet. Wenn der Motor bremst und regenerative Leistung erzeugt, wobei eine Spannung an einem Zwischenkreiskondensator ansteigt, wird der Transistor durch einen Spannungspuls angesteuert. Wenn der Transistor durch einen Defekt des Transistors dauerhaft einschaltet, fließt ein Strom größer als ein Sollwert zu dem Widerstand und es erhöht sich die Temperatur des Widerstands. Das Schaltelement wird von einem auf Temperatur ansprechendes Element angesteuert, um den Stromfluss durch den Widerstand zu unterbrechen.

Der Erfindung liegt nun die Aufgabe zugrunde, einen Pulswiderstand anzugeben, der die aufgeführten Nachteile nicht mehr aufweist.

Diese Aufgabe wird erfindungsgemäß mit den Merkmalen des Anspruchs 1 gelöst. Vorteilhafte Ausführungsformen sind in den abhängigen Ansprüchen definiert.

Dadurch, dass anstelle von abschaltbaren Halbleiterschaltern nun wenigstens zwei zweipolige Subsysteme verwendet werden, kann das Widerstandselement des Pulswiderstandes direkt in Reihe zu den elektrisch in Reihe geschalteten Subsystemen geschaltet werden. Durch die Wahl der Anzahl der Subsysteme kann man die Feinstufigkeit der Steuerbarkeit eines Bremsstromes bestimmen. Da die zweipoligen Subsysteme jeweils einen unipolaren Speicherkondensator aufweisen, benötigt dieser erfindungsgemäße Pulswiderstand keinen Gleichspannungskondensator mehr. Somit entfällt auch die Bedingung, dass dieser Pulswiderstand in unmittelbarer räumlicher Nähe eines Gleichspannungs-Zwischenkreiskondensators eines lastseitigen Stromrichters angeordnet sein muss. D.h., dieser erfindungsgemäße Pulswiderstand kann mittels zweier Zuleitungen, beispielsweise Leitungslitzen, mit einer positiven und negativen Sammelschiene eines lastseitigen Stromrichters verbunden sein.

Durch das Zu- und Wegschalten von Subsystemen des erfindungsgemäßen Pulswiderstandes wird ein Bremsstrom in Stufen gesteuert, d.h., der erfindungsgemäße Pulswiderstand weist kein Zweipunktverhalten mehr auf. Dadurch entstehen in den Zuleitungen des Pulswiderstandes keine hohen Wechselstromkomponenten des Stromes mehr.

Bei einer vorteilhaften Ausführungsform des Pulswiderstandes sind die Speicherkondensatoren der elektrisch in Reihe geschalteten Subsysteme derart bemessen, dass eine in parasitären Induktivitäten der Zuleitungen und des Widerstandselementes gespeicherte Energie klein gegenüber einer in diesen Speicherkondensatoren gespeicherten Energie ist. Dadurch wird eine resultierende Überspannung beim Abschalten eines Bremsstromes minimal. Diese Bedingung wird dadurch erreicht, dass die Speicherkondensatoren genügend groß bemessen sind.

Bei einer weiteren vorteilhaften Ausführungsform des Pulswiderstandes sind die Speicherkondensatoren der elektrisch in Reihe geschalteten Subsysteme derart bemessen, dass die aus Widerstandselement und Speicherkondensatoren gebildete Zeitkonstante klein gegenüber der Dauer eines jeden Schaltzustandes der Subsysteme ist. Dadurch wird verhindert, dass die Spannungen an den unipolaren Speicherkondensatoren der elektrisch in Reihe geschalteten Subsystemen unnötig während eines jeden Schaltvorganges schwanken. Diese Bedingung wird ebenfalls durch genügend große Speicherkondensatoren erfüllt.

Zur weiteren Erläuterung der Erfindung wird auf die Zeichnung näher Bezug genommen, in der eine Ausführungsform eines erfindungsgemäßen Pulswiderstandes schematisch veranschaulicht ist.
- FIG 1: zeigt ein Ersatzschaltbild eines lastseitigen Stromrichters eines aus dem Stand der Technik bekannten U-Umrichters, in der
- FIG 2: ist ein Ersatzschaltbild eines bekannten pulsgesteuerten Widerstandes dargestellt, die
- FIG 3: zeigt ein Ersatzschaltbild eines erfindungsgemäßen Pulswiderstandes, und die
- FIG 4 und 5: zeigen jeweils eine Schaltungsanordnung eines Subsystems.

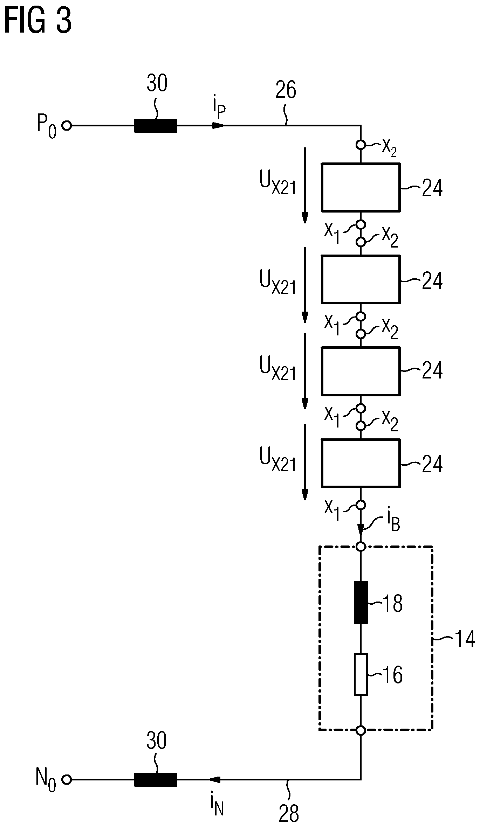

Gemäß dem Ersatzschaltbild des erfindungsgemäßen Pulswiderstandes nach FIG 3 sind vier Subsysteme 24 und ein Widerstandselement 14 elektrisch in Reihe geschaltet. Die Anzahl der Subsysteme 24 ist in dieser Darstellung beispielhaft. D.h., die Anzahl der Subsysteme 24, die elektrisch in Reihe geschaltet sind, ist beliebig. Beispielsweise bestimmt die Anforderung an einer Feinstufigkeit der Steuerbarkeit eines Bremsstromes i_{B} die Anzahl der verwendeten Subsysteme 24. Dieser Pulswiderstand wird mittels einer Zuleitung 26 und 28 mit einer Sammelschiene P₀ und N₀ eines lastseitigen Stromrichters 2 elektrisch leitend verbunden. Bestimmte Anforderungen an diesen Zuleitungen 26 und 28 wie bei den Zuleitungen 20 und 22 des bekannten Pulswiderstandes gemäß FIG 2 werden beim erfindungsgemäßen Pulswiderstand nicht gestellt.

Um den Bremsstrom i_{B} zu steuern, müssen nur die einzelnen Subsysteme 24 zu- oder weggeschaltet werden, wobei alle gleichzeitig oder nacheinander zu- oder weggeschaltet werden.

Im Ruhezustand, wenn der Bremsstrom i_{B} Null ist, sind alle Subsysteme 24 in einem Schaltzustand, in denen die Klemmenspannungen U_{X21} der Subsysteme 24 jeweils unabhängig von der Klemmenstromrichtung von Null verschiedene Werte annehmen und jedes Subsystem 24 je nach Klemmenstromrichtung Energie aufnimmt bzw. abgibt. Dieser Schaltzustand wird gemäß der DE 101 03 031 A1 als Schaltzustand II bezeichnet. Um den maximalen Bremsstrom i_{Bmax} zu realisieren, werden alle Subsysteme in einem Schaltzustand gesteuert, in denen die Klemmenspannungen U_{X21} der Subsysteme 24 jeweils unabhängig von der Klemmenstromrichtung den Wert Null annehmen. Dieser Schaltzustand wird gemäß der DE 101 03 031 A1 mit Schaltzustand I bezeichnet. Um feinstufige Zwischenwerte des Bremsstromes (0<i_{B}<i_{Bmax}) zu realisieren, werden in n Subsystemen 24 nur eines bis n-1Subsysteme 24 in dem Schaltzustand I geschaltet. Die verbleibenden Subsysteme 24 werden im Schaltzustand II belassen.

Entsprechend dem aus DE 101 03 031 A1 bekannten Verfahren zur Symmetrierung der an den Speicherkondensatoren 40 der n Subsystemen 24 anstehenden Spannungen U_{C} werden innerhalb einer Reihenschaltung von n Subsystemen 24 jeweils die Subsysteme 24 mit den höchsten Kondensator-Spannungen U_{C} bevorzugt in den Schaltzustand I geschaltet.

Um diese Kondensatorspannungen U_{C} nicht unnötig stark während der Schaltvorgänge schwanken zu lassen, ist es vorteilhaft und sinnvoll, die Dauer jedes Schaltzustandes klein gegen die aus den ohmschen Widerstandelement 14 und den Speicherkondensatoren 40 der n Subsystemen 24 gebildete Zeitkonstante zu wählen. Dies wird durch genügend große Speicherkondensatoren 40 der n Subsysteme 24 erreicht. Eine zweite Möglichkeit besteht darin, die Schaltfrequenz genügend hoch zu wählen.

Um eine beim Abschalten des Bremsstromes i_{B} resultierende Überspannung der Speicherkondensatoren 40 der n Subsysteme 24 zu minimieren, ist es anzustreben, die in den parasitären Induktivitäten 30 und 18 der Zuleitungen 26,28 und des Widerstandselementes 14 gespeicherten Energien klein gegen die in den Speicherkondensatoren 40 der n Subsystemen 24 gespeicherten Energien zu halten. Dies kann immer durch genügend groß bemessene Speicherkondensatoren 40 der n Subsystemen 24 erreicht werden.

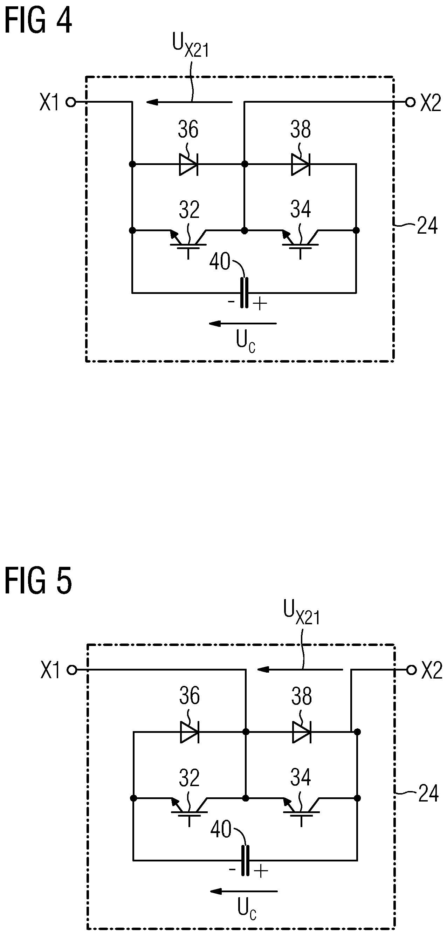

Die FIG 4 zeigt eine aus der DE 101 03 031 A1 bekannte einfache Schaltungsanordnung für das Subsystem 24 des Pulswiderstandes nach FIG 3. Die Schaltungsanordnung nach FIG 5 stellt eine funktional völlig gleichwertige Variante dar. Dieses bekannte zweipolige Subsystem 24 weist zwei abschaltbare Halbleiterschalter 32 und 34, zwei Dioden 36 und 38 und einen unipolaren Speicherkondensator 40 auf. Die beiden abschaltbaren Halbleiterschalter 32 und 34 sind elektrisch in Reihe geschaltet, wobei diese Reihenschaltung elektrisch parallel zum Speicherkondensator 40 geschaltet ist. Jedem abschaltbaren Halbleiterschalter 32 und 34 ist eine der beiden Dioden 36 und 38 derart elektrisch parallel geschaltet, dass diese zum korrespondierenden abschaltbaren Halbleiterschalter 32 oder 34 antiparallel geschaltet ist. Der unipolare Speicherkondensator 40 des Subsystems 24 besteht entweder aus einem Kondensator oder einer Kondensatorbatterie aus mehreren solchen Kondensatoren mit einer resultierenden Kapazität C₀. Der Verbindungspunkt von Emitter des abschaltbaren Halbleiterschalters 32 und Anode der Diode 36 bildet eine Anschlussklemme X1 des Subsystems 24. Der Verbindungspunkt der beiden abschaltbaren Halbleiterschalter 32 und 34 und der beiden Dioden 36 und 38 bilden eine zweite Anschlussklemme X2 des Subsystems 24.

In der Ausführungsform des Subsystems 24 gemäß FIG 5 bildet dieser Verbindungspunkt die erste Anschlussklemme X1. Der Verbindungspunkt von Drain des abschaltbaren Halbleiterschalters 34 und Kathode der Diode 38 bildet die zweite Anschlussklemme X2 des Subsystems 24.

Im Schaltzustand I ist der abschaltbare Halbleiterschalter 32 eingeschaltet und der abschaltbare Halbleiterschalter 34 ausgeschaltet. Um den Schaltzustand II zu erreichen, sind der abschaltbare Halbleiterschalter 32 ausgeschaltet und der ausschaltbare Halbleiterschalter 34 eingeschaltet. Im Schaltzustand I ist die Klemmenspannung U_{X21} des Systems 24 gleich Null, wogegen im Schaltzustand II die Klemmenspannung U_{X21} gleich der am Speicherkondensator 40 anstehenden Kondensatorspannung U_{C} ist.

Durch die Wahl der Anzahl der elektrisch in Reihe geschalteten Subsysteme 24 des Pulswiderstandes nach FIG 3 kann dieser erfindungsgemäße Pulswiderstand mit einfachen Mitteln an jede beliebige genormte Mittelspannung angepasst werden. Mit der Wahl der Anzahl von Subsystemen 24 des Pulswiderstandes nach FIG 3 wird ebenfalls die an jedem Speicherkondensator 40 anstehende Kondensatorspannung U_{C} vorbestimmt. Diese Kondensatorspannung U_{C} bestimmt auch die Spannungsfestigkeit der beiden abschaltbaren Halbleiterschalter 32 und 34. Als abschaltbarer Halbleiterschalter 32 und 34 werden wie in den Figuren 4 und 5 dargestellt Insulated-Gate-Bipolar-Transistoren (IGBT) verwendet. Ebenfalls können MOS-Feldeffekttransistoren, auch als MOSFET bezeichnet, verwendet werden.

Mit diesem erfindungsgemäßen Pulswiderstand lassen sich alle zuvor genannten Nachteile a) bis d) vermeiden. Dieser Pulswiderstand nach der Erfindung weist darüber hinaus noch die folgenden Vorzüge auf:
- Feinstufige Steuerbarkeit des Bremsstromes i_{B} in mehreren Zwischenstufen, entsprechend der Anzahl der reihengeschalteten Subsysteme 24.
- Einheitliche Realisierung mit den aus der
   DE 101 03 031 A1 bekannten Subsystemen.

Die Summe dieser Eigenschaften rechtfertigt, insbesondere für Umrichter im höheren Spannungs- und Leistungsbereich, die höhere Anzahl an Bauelementen.

## Patentansprüche

1. Pulswiderstand für einen Umrichter im höheren Spannungs- und Leistungsbereich, wobei der Pulswiderstand wenigstens zwei zweipolige Subsysteme (24) und ein Widerstandselement (14) aufweist, wobei diese Subsysteme (24) und das Widerstandselement (14) elektrisch in Reihe geschaltet sind, wobei das zweipolige Subsystem (24) zwei abschaltbare Halbleiterschalter (32,34), zwei Dioden (36,38) und einen unipolaren Speicherkondensator (40) aufweist, wobei die beiden abschaltbaren Halbleiterschalter (32,34) elektrisch in Reihe geschaltet sind, und diese Reihenschaltung elektrisch parallel zum unipolaren Speicherkondensator (40) geschaltet ist, und wobei jedem abschaltbaren Halbleiterschalter (32,34) eine Diode (36,38) antiparallel geschaltet ist.

2. Pulswiderstand nach Anspruch 1, **dadurch g**e**kennzeichnet**, dass die Speicherkondensatoren (40) der zweipoligen Subsysteme (24) derart bemessen sind, dass eine in parasitären Induktivitäten (30,18) von Zuleitungen (26,28) und des Widerstandelements (14) gespeicherte Energie klein gegenüber einer in den Speicherkondensatoren (40) gespeicherte Energie ist.

3. Pulswiderstand nach Anspruch 1, **dadurch gekennzeichne**t, dass die Speicherkondensatoren (40) der zweipoligen Subsysteme (24) derart bemessen sind, dass die aus Widerstandselement (14) und Speicherkondensatoren (40) gebildete Zeitkonstante klein gegenüber der Dauer eines Schaltzustandes ist.

4. Pulswiderstand nach Anspruch 1, **dadurch gekennzeichnet, dass** die Anschlussklemmen (Xl,X2), eines jeden Subsystems (24) mit den Anschlüssen eines unteren abschaltbaren Halbleiterschalter (32) der elektrisch in Reihe geschalteten abschaltbaren Halbleiterschalter (32,34) elektrisch leitend verbunden sind.

5. Pulswiderstand nach Anspruch 1, **dadurch gekennzeichnet, dass** die Anschlussklemmen (X1,X2) eines jeden Subsystems (24) mit den Anschlüssen eines oberen abschaltbaren Halbleiterschalters (34) der elektrisch in Reihe geschalteten abschaltbaren Halbleiterschalter (32,34) elektrisch leitend verbunden sind.

6. Pulswiderstand nach einem der vorgenannten Ansprüche, **dadurch gekennzeichnet, dass** als abschaltbarer Halbleiterschalter (32,34) ein Insulated-Gate-Bipolar-Transistor vorgesehen ist.

7. Pulswiderstand nach einem der Ansprüche 1 bis 5, **dadurch gekennzeichnet, dass** als abschaltbarer Halbleiterschalter (32,34) ein MOS-Feldeffekttransistor vorgesehen ist.

8. Pulswiderstand nach einem der Ansprüche 1 bis 5, **dadurch gekennzeichnet, dass** als abschaltbarer Halbleiterschalter (32,34) Gate-Turn-Off-Thyristor vorgesehen ist.

9. Pulswiderstand nach einem der Ansprüche 1 bis 5, **dadurch gekennzeichnet, dass** als abschaltbarer Halbleiterschalter (32,34) ein Integrated-Gate-Commutated-Thyristor vorgesehen ist.

10. Umrichter mit einem Pulswiderstand nach einem der Ansprüche 1 bis 9.

## Claims

1. Pulse resistor for a converter in the moderately high voltage and power range, wherein the pulse resistor has at least two two-terminal subsystems (24) and a resistance element (14), these subsystems (24) and the resistance element (14) being electrically connected in series, wherein the two-terminal subsystem (24) comprises two turn-off capable semiconductor switches (32,34), two diodes (36,38) and a unipolar storage capacitor (40), the two turn-off capable semiconductor switches (32,34) being electrically connected in series, and this series circuit being electrically connected in parallel with the unipolar storage capacitor (40), and a diode (36,38) being connected in antiparallel with each turn-off capable semiconductor switch (32,34).

2. Pulse resistor according to Claim 1, **characterized in that** the storage capacitors (40) of the two-terminal subsystems (24) are designed to be of such a capacitance that an amount of energy stored in parasitic inductances (30, 18) of supply lines (26, 28) and of the resistance element (14) is small compared with an amount of energy stored in the storage capacitors (40).

3. Pulse resistor according to Claim 1, **characterized in that** the storage capacitors (40) of the two-terminal subsystems (24) are designed to be of such a capacitance that the time constant formed from the resistance element (14) and storage capacitors (40) is small compared with the period of a control state.

4. Pulse resistor according to Claim 1, **characterized in that** the connecting terminals (X1,X2) of each subsystem (24) are electrically conductively connected to the terminals of a lower turn-off capable semiconductor switch (32) of the turn-off capable semiconductor switches (32, 34) that are electrically connected in series.

5. Pulse resistor according to Claim 1, **characterized in that** the connecting terminals (X1,X2) of each subsystem (24) are electrically conductively connected to the terminals of an upper turn-off capable semiconductor switch (34) of the turn-off capable semiconductor switches (32, 34) that are electrically connected in series.

6. Pulse resistor according to any of the preceding claims, **characterized in that** an insulated gate bipolar transistor is provided as the turn-off capable semiconductor switches (32, 34) .

7. Pulse resistor according to any of Claims 1 to 5, **characterized in that** a MOS field effect transistor is provided as the turn-off capable semiconductor switches (32, 34).

8. Pulse resistor according to any of Claims 1 to 5, **characterized in that** a gate turn-off thyristor is provided as the turn-off capable semiconductor switches (32, 34).

9. Pulse resistor according to any of Claims 1 to 5, **characterized in that** an integrated gate commutated thyristor is provided as the turn-off capable semiconductor switches (32, 34) .

10. Converter having a pulse resistor according to any of Claims 1 to 9.

## Revendications

1. Résistance à impulsions pour un convertisseur dans le domaine de la haute tension et haute puissance, dans laquelle la résistance à impulsions a au moins deux sous-systèmes (24) bipolaires et un élément (14) de résistance, ces sous-systèmes (24) et l'élément (14) de résistance étant montés en série électriquement, le sous-système (24) bipolaire ayant deux interrupteurs (32, 34) à semi-conducteurs pouvant être ouverts, deux diodes (36, 38) et un condensateur (40) d'accumulation unipolaire, les deux interrupteurs (32, 34) à semi-conducteurs pouvant être ouverts étant montés en série électriquement et ce montage série est monté électriquement en parallèle avec le condensateur (40) d'accumulation unipolaire et une diode (36, 38) est montée tête-bêche avec chaque interrupteur (32, 34) à semi-conducteurs pouvant être ouvert.

2. Résistance à impulsions suivant la revendication 1, **caractérisée en ce que** les condensateurs (40) d'accumulation des sous-systèmes (24) bipolaires sont dimensionnés, de manière à ce qu'une énergie emmagasinée dans des inductances (30, 18) parasites de lignes (26, 28) d'arrivée de l'élément (14) de résistance soit plus petite qu'une énergie emmagasinée dans les condensateurs (40) d'accumulation.

3. Résistance à impulsions suivant la revendication 1, **caractérisée en ce que** les condensateurs (40) d'accumulation des sous-systèmes (24) bipolaires sont dimensionnés, de manière à ce la constante de temps formée de l'élément (14) de résistance et des condensateurs (40) d'accumulation soit petite par rapport à la durée d'un état de fermeture des interrupteurs.

4. Résistance à impulsions suivant la revendication 1, **caractérisée en ce que** les bornes (X1, X2) de chaque sous-système (24) sont reliées d'une manière conductrice de l'électricité aux bornes d'un interrupteur (32) à semi-conducteurs inférieur pouvant être ouvert parmi les interrupteurs (32, 34) à semi-conducteurs pouvant être ouverts montés en série électriquement.

5. Résistance à impulsions suivant la revendication 1, **caractérisée en ce que** les bornes (X1, X2) de chaque sous-système (24) sont reliées d'une manière conductrice de l'électricité aux bornes d'un interrupteur (34) à semi-conducteurs supérieur pouvant être ouvert parmi les interrupteurs (32, 34) à semi-conducteurs pouvant être ouverts montés en série électriquement.

6. Résistance à impulsions suivant l'une des revendications précédentes, **caractérisée en ce qu'**un transistor bipolaire à grille isolée est prévu comme interrupteur (32, 34) à semi-conducteurs pouvant être ouvert.

7. Résistance à impulsions suivant l'une des revendications 1 à 5, **caractérisée en ce qu'**un transistor à effet de champ MOS est prévu comme interrupteur (32, 34) à semi-conducteurs pouvant être ouvert.

8. Résistance à impulsions suivant l'une des revendications 1 à 5, **caractérisée en ce qu'**un gate-turn-off-thyristor est prévu comme interrupteur (32, 34) à semi-conducteurs pouvant être ouvert.

9. Résistance à impulsions suivant l'une des revendications 1 à 5, **caractérisée en ce qu'**un integrated-gate-commutated-thyristor est prévu comme interrupteur (32, 34) à semi-conducteurs pouvant être ouvert.

10. Convertisseur ayant une résistance à impulsions suivant l'une des revendications 1 à 9.
